Europäisches Patentamt

European Patent Office

Office européen des brevets

(11) Publication number: **0 195 767 B1**

# EUROPEAN PATENT SPECIFICATION

(45) Date of publication of patent specification: **27.01.93**  (51) Int. Cl.⁵: **G03C 5/00**, C09J 201/00

(21) Application number: **86870020.4**

(22) Date of filing: **18.02.86**

(54) **Composition and method for preparing a pattern of an adhesive.**

(30) Priority: **19.02.85 US 702573**

(43) Date of publication of application:
**24.09.86 Bulletin 86/39**

(45) Publication of the grant of the patent:
**27.01.93 Bulletin 93/04**

(84) Designated Contracting States:
**AT BE CH DE FR GB IT LI LU NL SE**

(56) References cited:
**EP-A- 0 142 463**

**DERWENT JAPANESE PATENT REPORT, vol. 78, no. 44, Chemistry, Section G, 01 December 1978; no. 7630972x**

**RESEARCH DISCLOSURE, no. 203, March 1981, pp. 126-127, Havant, Hampshire, GB; no. 203 "Radiation-curable composition for restorative and /or protective treatment of photographic elements"**

(73) Proprietor: **U C B, S.A.**
**326, Avenue Louise, Bte 7**
**B-1050 Bruxelles(BE)**

(72) Inventor: **Fricano, Patricia A.**
**2551, South Seymour Place**
**West Allis, WI 53227(US)**
Inventor: **Cordts, Howard P.**
**944, 17th Avenue**
**Grafton, WI 53024(US)**

(74) Representative: **Dusseldorp, Raymond et al**
**U.C.B. S.A. Département D.T.B. 326, avenue Louise, Bte 7**
**B-1050 Bruxelles(BE)**

**Description**

The present invention relates generally to the art of polymerisation of resin materials by exposure to an energy radiation. More specifically, the invention relates to the use of ultra-violet light curable resins to prepare a pattern of an adhesive. Still more specifically, the present invention relates to the accurate preparation of detailed patterns of adhesive compositions by applying a mixture of an adhesive and an ultra-violet light curable system as a layer and exposing the layer through a mask to cure a portion of the layer. The uncured portion is removed, such as by solvent washing to produce a pattern of adhesive material.

The use of ultra-violet light to cure certain classes of resin materials has been known for many years. An ultra-violet light curable system requires two main components: an unsaturated resin and a photoinitiator. The resin which is used in such systems may itself comprise a single unsaturated oligomer or monomer or a mixture thereof and it is known that a wide variety of other materials can be added, e.g. to provide coloration, to improve toughness, to enhance physical properties, etc.. The state of the art (Article 54(3)) also comprises the earlier European Patent Application EP-A-0 142 463 published on the 22nd May, 1985, which describes liquid solventless compositions containing a thermosetting epoxy resin, a photo-polymerisable compound, a heat-activatable hardener for the epoxy resin and optionally a photo-polymerisation catalyst for the photo-polymerisable compound. This composition is specifically designed for the preparation of pre-pregs for making fiberglass reinforced laminates. Earlier European Patent application EP-A-0-142 463, however, does not disclose a composition comprising an epoxy resin in admixture with an urethane acrylate resin, which is the preferred energy curable resin for use in the method of preparing a pattern of an adhesive according to the invention.

Whatever the composition chosen, the known reactive mechanism is the light energy excitation of the photoinitiator to generate free radicals, which will in turn initiate radical polymerisation at the sites of resin unsaturation.

The process of ultra-violet light polymerisation actually occurs in three stages: initiation, propagation and termination. Each will be discussed briefly as background to the present invention. With respect to initiation, the most commonly used photoinitiators absorb radiation energy over the range of 250-480 nanometers, resulting in an electronically excited state photoinitiator. Such excited state is generally the triplet state in the case of the well known class of aromatic ketone photoinitiators. From the excited state, most photoinitiators follow one of two mechanisms to create free radical species. Type 1 photoinitiators undergo homolytic bond cleavage resulting in the formation of two free radical species. If the absorbed energy causes the bond between the carbonyl and the adjacent carbon atom to break (e.g. with certain ketones), the reaction is called a Norrish Type 1 cleavage. Type 2 photoinitiators, on the other hand, undergo a hydrogen abstraction from a second molecule in the resin system to produce two different free radical species. Depending upon a number of well recognized variables, the various types of free radical groups discussed above can react with unsaturated materials to initiate polymerisation.

Propagation occurs during that portion of the polymerisation process when the resin system increases in molecular weight and results in the formation of a polymer by the successive addition of monomer units. Propagation continues until termination occurs.

Termination may also occur in several ways. For example, a combination can occur between two radicals of different polymer chains, resulting in chain extension and an increase in molecular weight. Chain transfer can also occur, in which the radical of one chain is reacted with a component from another chain. Chain transfer usually results in polymers having decreased molecular weights. Termination can also occur via reaction of the free radical with oxygen. The latter also generally leads to lower molecular weight polymers and the formation of peroxide and hydroperoxide by-products.

Energy curable resin systems have a wide variety of applications, one of which will be mentioned here for the purpose of illustrating such uses and for the purpose of illustrating a useful property of energy curable systems in general. That application is the use of energy curable resin systems for the preparation of printing plates.

It is known that energy curable systems can be employed to form coatings on substrates, it is also known that such coatings can be selectively cured to provide cured areas and uncured areas, such as for example by exposure of a layer of uncured resin through an image bearing photomask. After such selective exposure, the layer will include areas which are cured and areas which remain uncured. It is known that the uncured areas can be washed away from a coated substrate, leaving the cured areas attached to the substrate. Moreover, it is known that the line between where the system has been exposed and where it has not been exposed is very defined by the edges of the photomask, because the polymerisation itself is strictly limited to the areas exposed to the energy radiation and will not extend to unexposed areas. If the

EP 0 195 767 B1

resin system employed in the above-illustrated systems is properly selected, the resultant patterned product can be used as a printing plate, and the overall process results in increased efficiencies and lower costs over other procedures known to the printing plate art.

While the prior art has recognized this particular application of energy curable systems, there are a number of other processes for making patterns that are still being practiced by outdated, time consuming and costly techniques. Examples include the hand lay up of patterns or the well-known silk screening process. Achieving precise patterns using such techniques is difficult, and there are a number of intricate patterns which are especially difficult to prepare using known procedures. Furthermore, greater accuracy in pattern making is becoming more essential, as for example, the complex patterns employed in touch pads for electronic devices, electric circuit boards and also in non-technical areas such as the preparation of ornamental filigree work.

A method for facilitating the preparation of such accurate patterns which eliminates the need to use outmoded techniques such as silk screening and hand lay-up would represent a significant advance in the art.

It is a primary object of the present invention to provide a method of preparing accurate patterns of adhesives to produce products which include patterned adhesives.

Another object of the present invention is to provide a technique for preparing patterns of adhesives which can be accomplished more accurately and more quickly than using techniques known to the art, such as silk screening and hand lay up.

A further object of the present invention is to provide a technique for preparing patterned adhesives, which may be used with a wide variety of adhesives to produce patterned adhesives which may be employed in applications where very precise and delicate adhesive boundaries are required.

A still further object of the present invention is to provide products which include patterns of adhesive which may be employed in electronic and non-electronic applications.

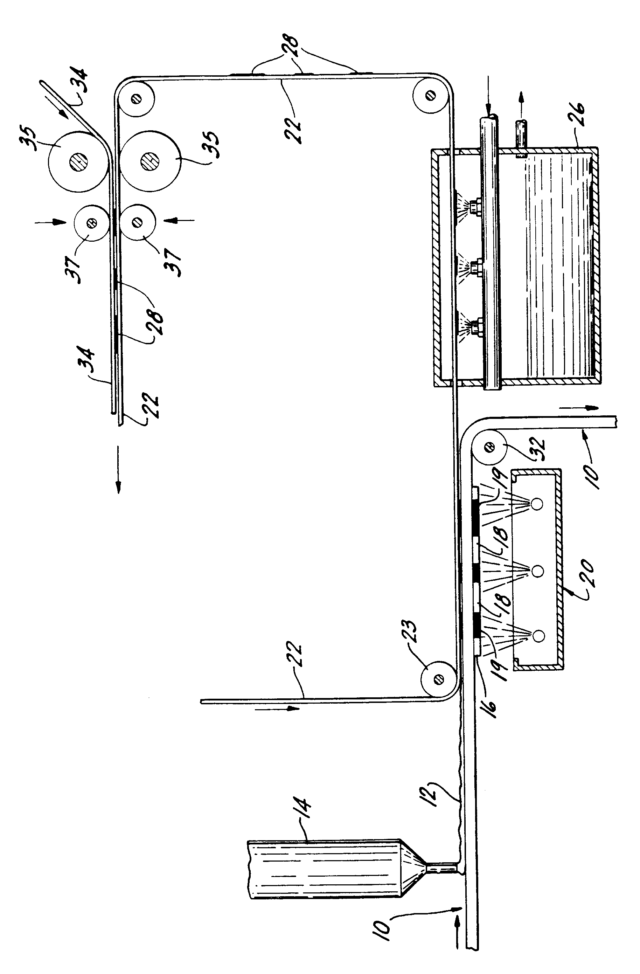

How these and further objects of the invention are accomplished will be described in the following specification, taken in conjunction with the single drawing. Generally, however, the objects are accomplished by a method of preparing a pattern of an adhesive comprising the steps of :

(a) preparing a blend of an adhesive resin selected from the group consisting of thermosetting adhesive resins and thermoplastic adhesive resins mixed with a resin which may be cured by exposure to an energy radiation;

(b) applying a layer of said blend to a support;

(c) applying a film of a material to which it is desired to apply said pattern onto that surface of said layer opposite said support;

(d) exposing said layer to a pattern of said energy radiation to selectively cure said layer;

(e) removing said support; and

(f) removing from said layer that portion of said layer which was not exposed to said radiation.

The layer of adhesive resin is preferably formed by applying the blend of adhesive and energy curable resin to a transparent support from which it can be easily removed, such as glass or mylar (poly(ethylene terephthalate)). A film or sheet of a material to be bonded to the adhesive is then placed onto the adhesive layer. Following this step, a high contrast negative mask is applied to the opposite side of the transparent support and ultra-violet light or other energy radiation source is applied through the mask and support to cure that portion of the adhesive layer which is clear in the mask. The adhesive itself is unaffected by this exposure, but the combination of the adhesive and energy curable resin system is cured to such a degree that the exposed portion is immune to a wash step. Following exposure, the support and mask are removed and the adhesive layer and material film or sheet are subjected to a washing step. Depending on the adhesive and energy curable resin system selected, the solvent wash can be water/detergent system, an alkali wash or an organic solvent wash. The final step of the process is accomplished by curing the adhesive, for example in a bonding process, by the application of heat and/or pressure as is known to the particular adhesive art.

The Figure of the accompanying drawing shows in schematic form the preferred embodiment of the present invention and illustrates the adhesive coating, the material sheet application, the energy radiation curing, the support removal, the solvent wash and bonding steps of the preferred method.

The present invention may be employed with a wide variety of adhesives, a wide variety of energy curable systems and for a wide variety of end use applications. It should also be understood at the outset that the use of the term energy radiation curing as used herein can mean ultra-violet radiation or electron beam curing, as both are known in the art. One skilled in the art, after reading the following specification, could readily select the appropriate type of radiation for a particular energy curable resins and photoinitiator.

It should also be stated at the outset that apparatus for performing the steps of the present invention

3

can be selected from known devices, and that the length and intensity of the energy radiation curing step can vary widely depending upon factors which will be readily apparent to those skilled in the art. Moreover, the chemical systems to be described shortly are mentioned for purposes of illustration only, and those skilled in the art will readily be able to adapt the teachings of the present invention to other systems after the specification is read and understood.

For illustration, three preferred embodiments of the present invention will be described. In each case, an ultra-violet light curable urethane acrylate will be used as the energy curable resin. In a first embodiment, a thermoplastic epoxy resin will be used as the adhesive material. In a second embodiment, a thermoplastic acetate resin will be used as the adhesive material. In the third embodiment, a thermosetting epoxy resin will be used as the adhesive material.

Before proceeding to the examples, it will be helpful to illustrate the breadth of the invention by providing examples of other energy curable resin systems which may be employed. Suitable energy curable resins include acrylic or methacrylic terminated polymers, epoxy acrylates, urethane acrylates, etc.

As mentioned previously, a photoinitiator will typically be used in the present invention, especially if the energy cure is to be by ultra-violet radiation. Examples of suitable photoinitiators which may be used in the present invention include organic carbonyl compounds such as benzophenones, benzanthrones, benzoins and the alkyl ethers thereof, 2,2-diethoxyacetophenone, 2,2-dimethoxy-2-phenyl-acetophenone, 4'-phenoxy-2,2-dichloroacetophenone, (2-hydroxycyclohexyl) phenyl ketone, 2,2-dimethyl-2-hydroxyacetophenone, oximes and copolymerisable benzophenone derivatives.

Adhesives with which the present invention has particular utility include the two basic groups of thermosetting and thermoplastic adhesive resin. Included in those groups are epoxies, urethanes, polyesters, polyvinyl acetates, polyamides, synthetic rubbers, etc.

Now that the basic components employed in the present invention have been described, the method of making patterned adhesives can be described by reference to the Figure. The Figure is diagramatic and shows a transparent support 10, such as glass or mylar, which is used to support an applied layer 12 of a mixture of an adhesive and an energy curable resin. In the Figure, layer 12 is shown being applied from a tank 14. A material sheet 22 to be bonded to the adhesive layer 12 is applied to the side of layer 12 opposite support 10, such as by a roller 23. Following application of material sheet 22, a mask 16 is applied to the side of support 10 remote from layer 12, mask 16 including clear portions 18 and masked portions 19. The composite is exposed to energy radiation, e.g. by lamps 20.

At this point in the process, the material sheet 22 with pattern 28 adhering thereto is stripped from support 10, e.g. by roller 32. The next step in the process comprises washing uncured resin from layer 12 in a wash tank 26. This process will leave a pattern 28 of adhesive on material sheet 22.

To illustrate one end use of the patterned adhesive, another sheet 34 to be bonded to the pattern 28 is applied to the exposed surface of the pattern 28 and bonded thereto under the application of heat and pressure. In the illustration, heat is applied through rollers 35 and pressure is applied by nip rollers 37. Obviously the process could take place using single sheets instead of roll materials and/or could be performed in single steps rather than the continuous method illustrated.

With regard to the amounts of the various materials in layer 12, between about 5-95% of the mixture is the selected adhesive and between about 95-5% of the mixture is the energy curable resin system. Preferably, the mixture contains at least 75% of the adhesive. The ratios may vary widely between these outer limits, depending on the end use properties desired. The photoinitiator may constitute from about 0.1% to about 5.0% of the energy curable resin system.

We have also found that the addition of the energy curable resin to the adhesive does not adversely affect the bond strength of the adhesive. This is illustrated by the following Examples 1A and B, 2A and B and 3A and B. In each example, a zinc plated steel panel was first coated with a 25.4 micrometers coating of the plain adhesive and then with a 25.4 micrometers coating of the same adhesive containing 20 parts by weight of an ultra-violet light curable urethane acrylate. Those panels containing the urethane acrylate were exposed to UV light to cure the composition. The panels were clamped together and placed in an oven at 75°C until bonding was completed. Peel strength was then determined using ASTM D-903. The results of the tests are summarized in Table 1, where it can be noted that in all cases, the mixed adhesive retained at least 90% of the peel strength determined for the virgin adhesive.

Examples 1A and 1B.

A. A homogenous mixture of 50 parts by weight of a bisphenol A type epoxy resin (1) and 50 parts by weight of a polyamide hardener (2) was prepared. The mixture was applied at a thickness of 25.4 micrometers to metal panels (22 gauge, Granodine 108 pretreated). Two panels so prepared were clamped

4

EP 0 195 767 B1

together and baked for two hours at 75°C and the peel strength was determined.

B. A homogenous mixture of 40 parts by weight of the above-mentioned epoxy resin, 40 parts by weight of the above-mentioned hardener and 20 parts by weight of an ultra-violet light curable urethane acrylate (3) was prepared. The mixture was applied at a thickness of 25.4 micrometers to two metal panels and was then exposed to 6.2 W/cm$^2$ UV light for 2 minutes. Following exposure the panels were clamped together, baked for two hours at 75°C and the peel strength was determined.

(1) D.E.R. 332 sold by Dow Chemical.

(2) Polyamide 815 sold by Ciba Geigy.

(3) Chempol 29-4936 sold by Freeman Chemical Company and containing 0.25% 2,2-dimethoxy-2-phenyl-acetophenone (Irgacure 651 photoinitiator sold by Ciba Geigy).

Examples 2A and 2B.

A. 40 parts by weight of a thermoplastic epoxy adhesive (4) were mixed with 60 parts by weight methyl ethyl ketone. A 63.5 micrometers coating of this mixture was applied to two metal panels and the solvent was allowed to evaporate. Following evaporation, the panels were clamped together, baked for two hours at 75°C and the peel strength was determined.

B. 80 parts by weight of the mixture prepared in Example 2A were mixed with 20 parts by weight of the aforementioned urethane acrylate (3). A 50.8 micrometers coating of this mixture was applied to two metal panels and the solvent was allowed to evaporate. Following evaporation, the panels were exposed as in Example 1B, clamped together, baked for two hours at 75°C and the peel strengths were determined.

(4) D.E.R. 684 sold by Dow Chemical.

Examples 3A and 3B.

A. 25 parts by weight of a thermoplastic acetate adhesive (5) and 75 parts by weight of methyl ethyl ketone were blended to form a homogenous mixture. A 101.6 micrometers coating thereof was applied to two metal panels as aforesaid and the solvent was allowed to evaporate, following which the panels were clamped together, baked for two hours at 75°C and the peel strength was determined.

B. 24 parts by weight of the aforementioned thermoplastic acetate adhesive, 71 parts by weight methyl ethyl ketone and 5 parts by weight of the aforementioned urethane acrylate (3) were blended together to form a homogenous mixture. A 83.8 micrometers coating thereof was applied to two metal panels and the solvent was allowed to evaporate. The panels were then exposed to ultra-violet light as in Example 1B. Following exposure, the panels were clamped together, baked for two hours at 75°C and the peel strength was determined.

(5) VAGH sold by Union Carbide, a medium molecular weight, partially-hydrolysed vinyl chloride-vinyl acetate resin.

## TABLE 1

### PEEL STRENGTH

|  | Non-UV cured virgin adhesive | UV cured urethane acrylate blend | % retained |
|---|---|---|---|
| Thermosetting Epoxy | 35 (1A) | 32 (1B) | 91.5% |
| Thermoplastic Epoxy | 28 (2A) | 26 (2B) | 93.0% |
| Thermoplastic Acetate | 9.5 (3A) | 9.4 (3B) | 99.0% |

To illustrate the method of making patterned adhesives of the present invention, three additional Examples (4-6) will be described.

Example 4.

5

A 25.4 micrometer thick coating of the resin mixture prepared in Example 1B was applied on a 127 micrometers Mylar sheet. A separate film of a UV curable resin having a thickness of 3.175 millimeters was applied over the 25.4 micrometer thick coating. The uncoated side of the composite was then laid on top of a high contrast negative mask (with the appropriate pattern). Ultra-violet light was then shown through the negative (6.2 W/cm$^2$ for five minutes), following which the Mylar support was stripped from the composite. Unexposed resin was removed using a water/detergent wash. Following this step, the U.V. cured casting was clamped to a substrate and baked for two hours at 75°C. Bonding was completed at that point.

Example 5.

A 25.4 micrometer thick coating of the resin mixture prepared in Example 2B was applied on a 127 micrometers Mylar sheet and the solvent was allowed to evaporate. A separate film of a UV curable resin having a thickness of 3.175 millimeters was applied over the 25.4 micrometer thick coating. The uncoated side of the composite was then laid on top of a high contrast negative mask (with the appropriate pattern). Ultra-violet light was then shown through the negative as described in Example 4, following which the Mylar support was stripped from the composite. Unexposed resin was removed using a water/detergent wash. Following this step, the U.V. cured casting was clamped to a substrate and baked for two hours at 75°C. Bonding was completed at that point.

Example 6.

A 25.4 micrometer thick coating of the resin mixture prepared in Example 3B was applied on a 127 micrometers Mylar sheet and the solvent was allowed to evaporate. A separate film of a UV curable resin having a thickness of 3.175 millimeters was applied over the 25.4 micrometer thick coating. The uncoated side of the composite was then laid on top of a high contrast negative mask (with the appropriate pattern). Ultra-violet light was then shown through the negative as described in Example 4, following which the Mylar support was stripped from the composite. Unexposed resin was removed using a water/detergent wash. Following this step, the UV cured casting was clamped to a substrate and baked for two hours at 75°C. Bonding was completed at that point.

While the present invention has been described by reference to several specific embodiments, it is not to be limited thereby, but it is to be limited solely by the claims which follow.

**Claims**

1. A composition of matter comprising a blend of an adhesive resin selected from the group consisting of thermosetting adhesive resins and thermoplastic adhesive resins mixed with an urethane acrylate resin which may be cured by exposure to an energy radiation.

2. Composition according to claim 1, characterised in that said composition further comprises a photoinitiator for said urethane acrylate resin.

3. Composition according to claim 1 or 2, characterised in that said adhesive resin is selected from the group consisting of thermoplastic epoxy resins, thermoplastic acetate resins and thermosetting epoxy resins.

4. A method of preparing a pattern of an adhesive comprising the steps of:
   (a) preparing a blend of an adhesive resin selected from the group consisting of thermosetting adhesive resins and thermoplastic adhesive resins mixed with a resin which may be cured by exposure to an energy radiation;
   (b) applying a layer of said blend to a support;
   (c) applying a film of a material to which it is desired to apply said pattern onto that surface of said layer opposite said support;
   (d) exposing said layer to a pattern of said energy radiation to selectively cure said layer;
   (e) removing said support; and
   (f) removing from said layer that portion of said layer which was not exposed to said radiation.

5. Method according to claim 4, characterised in that said adhesive resin is selected from the group consisting of thermoplastic epoxy resins, thermoplastic acetate resins and thermosetting epoxy resins.

**6.** Method according to claim 4, characterised in that said support is substantially transparent to said energy radiation.

**7.** Method according to any of claims 4 to 6, characterised in that step (d) is carried out by exposing said layer through said support.

**8.** Method according to any of claims 4 to 7, characterised in that step (f) is accomplished by dissolving the unexposed portions of said layer using a water/detergent wash.

**Patentansprüche**

**1.** Zusammensetzung von Materie, die eine Mischung eines Klebharzes ausgewählt aus der Gruppe bestehend aus hitzehärtbaren Klebharzen und thermoplastischen Klebharzen gemischt mit einem Urethanacrylatharz, das durch Aussetzen einer Energiebestrahlung gehärtet werden kann, umfaßt.

**2.** Zusammensetzung nach Anspruch 1, gekennzeichnet dadurch, daß besagte Zusammensetzung weiter einen Photoinitiator für besagtes Urethanacrylatharz umfaßt.

**3.** Zusammensetzung nach Anspruch 1 oder 2, gekennzeichnet dadurch, daß besagtes Klebharz ausgewählt ist aus der Gruppe, bestehend aus thermoplastischen Epoxyharzen, thermoplastischen Acetatharzen und hitzehärtbaren Epoxyharzen.

**4.** Verfahren zur Herstellung eines Musters eines Klebstoffes, das die Schritte umfaßt :
(a) Herstellung einer Mischung eines Klebharzes ausgewählt aus der Gruppe bestehend aus hitzehärtbaren Klebharzen und thermoplastischen Klebharzen gemischt mit einem Harz, das durch Aussetzen einer Energiebestrahlung gehärtet werden kann, besteht;
(b) Auftragen einer Schicht besagter Mischung auf eine Unterlage;
(c) Auftragen eines Materialfilms, auf den besagtes Muster aufgetragen werden soll, auf die Oberfläche der besagten Schicht gegenüber besagter Unterlage;
(d) Aussetzen besagter Schicht einem Muster besagter Energiebestrahlung, um selektiv besagte Schicht zu härten;
(e) Entfernen besagter Unterlage; und
(f) Entfernen von besagter Schicht den Teil der besagten Schicht, der nicht der besagten Bestrahlung ausgesetzt war.

**5.** Verfahren nach Anspruch 4, gekennzeichnet dadurch, daß besagtes Klebharz ausgewählt ist aus der Gruppe, bestehend aus thermoplastischen Epoxyharzen, thermoplastischen Acetatharzen und hitzehärtbaren Epoxyharzen.

**6.** Verfahren nach Anspruch 4, gekennzeichnet dadurch, daß besagte Unterlage im wesentlichen durchlässig ist gegenüber der besagten Energiestrahlung.

**7.** Verfahren nach einem der Ansprüche 4 bis 6, gekennzeichnet dadurch, daß Schritt (d) durch Bestrahlung besagter Schicht durch besagte Unterlage ausgeführt wird.

**8.** Verfahren nach einem der Ansprüche 4 bis 7, gekennzeichnet dadurch, daß Schritt (f) durch Auflösen der unbestrahlten Teile besagter Schicht unter Verwendung einer Wasser-/Detergensspülung ausgeführt wird.

**Revendications**

**1.** Composition de matière comprenant un mélange d'une résine adhésive choisie dans le groupe consistant en les résines adhésives thermodurcissables et les résines adhésives thermoplastiques mélangée à une résine uréthanne acrylate durcissable par exposition à un rayonnement énergétique.

**2.** Composition selon la revendication 1, caractérisée en ce que ladite composition comprend en outre un photoinitiateur pour ladite résine uréthanne acrylate.

3. Composition selon la revendication 1 ou 2, caractérisée en ce que ladite résine adhésive est choisie dans le groupe consistant en les résines époxy thermoplastiques, les résines acétates thermoplastiques et les résines époxy thermodurcissables.

4. Procédé de préparation d'un motif d'un adhésif comprenant les stades suivants :
(a) préparation d'un mélange d'une résine adhésive choisie dans le groupe consistant en les résines adhésives thermodurcissables et les résines adhésives thermoplastiques mélangée à une résine durcissable par exposition à un rayonnement énergétique;
(b) application d'une couche dudit mélange sur un support;
(c) application sur la face de ladite couche opposée audit support d'un film d'un matériau sur lequel on désire appliquer ledit motif;
(d) exposition de ladite couche audit rayonnement énergétique filtré selon le motif pour durcir sélectivement ladite couche;
(e) élimination dudit support; et
(f) enlèvement de ladite couche de la partie qui n'a pas été exposée audit rayonnement.

5. Procédé selon la revendication 4, caractérisé en ce que ladite résine adhésive est choisie dans le groupe consistant en les résines époxy thermoplastiques, les résines acétates thermoplastiques et les résines époxy thermodurcissables.

6. Procédé selon la revendication 4, caractérisé en ce que ledit support est substantiellement transparent audit rayonnement énergétique.

7. Procédé selon l'une quelconque des revendications 4 à 6, caractérisé en ce que le stade (d) est exécuté par exposition de ladite couche au travers dudit support.

8. Procédé selon l'une quelconque des revendications 4 à 7, caractérisé en ce que le stade (f) est exécuté par dissolution de la partie non exposée de ladite couche par lavage au moyen d'un mélange eau/détergent.